# EUROPÄISCHE PATENTSCHRIFT

(11) **EP 3 127 406 B1**
(45) Veröffentlichungstag und Bekanntmachung des Hinweises auf die Patenterteilung: **24.02.2021**
(21) Anmeldenummer: 15709414.5
(22) Anmeldetag: 06.03.2015
(51) Int. Cl.: H05K 7/14, H02M 7/00

(54) **ELEKTROGERÄT UND VERFAHREN ZUR HERSTELLUNG EINES ELEKTROGERÄTES**
ELECTRIC DEVICE AND METHOD FOR PRODUCING AN ELECTRIC DEVICE
APPAREIL ÉLECTRIQUE ET PROCÉDÉ DE PRODUCTION D'UN APPAREIL ÉLECTRIQUE

(30) Priorität: 03.04.2014 DE 102014004799
(43) Veröffentlichungstag der Anmeldung: 08.02.2017
(73) Patentinhaber: SEW-EURODRIVE GmbH & Co. KG, 76646 Bruchsal (DE)
(72) Erfinder: NIKOLA, Joachim, 76703 Kraichtal (DE); KOLLAR, Hans Jürgen, 76646 Bruchsal (DE); MOMANN, Dirk, 76646 Bruchsal (DE)
(86) Internationale Anmeldenummer: PCT/EP2015/000502
(87) Internationale Veröffentlichungsnummer: WO 2015/149907

(56) Entgegenhaltungen:
- EP-A1- 1 069 673
- EP-A2- 2 416 484
- DE-A1-102007 012 818
- DE-A1-102012 005 622
- US-A1- 2003 179 594
- US-A1- 2009 251 843
- US-A1- 2010 091 464
- US-A1- 2013 265 737
- US-A1- 2013 308 257

## Beschreibung

Die Erfindung betrifft ein Elektrogerät und ein Verfahren zur Herstellung eines Elektrogerätes.

Aus der DE 10 2012 005 622 A1 ist eine Schaltungsanordnung für einen Umrichter mit einer Filteranordnung bekannt.

**Die** DE 10 2007 012 818 A1 **zeigt eine Halbleitervorrichtung mit Anschlüssen.**

**In der** US 2010/0091464 A1 **ist eine wärmeableitende Grundplattenstruktur, ein Modul aufweisend die wärmeableitende Grundplattenstruktur und ein Verfahren zur Herstellung der wärmeableitenden Grundplattenstruktur gezeigt.**

**Aus der** US 2013/0308257 A1 **ist eine Substrateinheit bekannt.**

**Die** US 2009/0251843 A1 **zeigt ein in einem Fahrzeug montiertes Elektrogerät und ein Fahrzeug, in dem das Elektrogerät montiert ist.**

**In der** US 2013/0265737 A1 **sind ein Verfahren und ein Gerät zur Verhinderung von Lichtbogenüberschlägen in Motorsteuerungsgeräten gezeigt.**

**Aus der** DE 10 2012 005622 A1 **ist eine Schaltungsanordnung und eine Anordnung von Kondensatoren bekannt.**

**Aus der** EP 2 416 484 A2 **ist ein Matrixkonverter bekannt.**

**Aus der** US 2003/179594 A1 **ist eine Anordnung zum Bewirken einer Basisinterferenz-Unterdrückung eines Matrixkonverters.**

**Aus der** EP 1 069 673 A1 **ist ein Netzfilter bekannt.**

Der Erfindung liegt daher die Aufgabe zugrunde, ein Elektrogerät und ein Verfahren zur Herstellung eines Elektrogerätes weiterzubilden, wobei die Sicherheit verbessert werden soll.

Erfindungsgemäß wird die Aufgabe bei dem Elektrogerät nach den in Anspruch 1 angegebenen Merkmalen gelöst und bei dem Verfahren zur Herstellung eines Elektrogeräts nach den in Anspruch 13 angegebenen Merkmalen gelöst.

Wichtige Merkmale der Erfindung bei dem Elektrogerät, insbesondere Umrichter, aufweisend eine Leiterplatte und ein Gehäuseteil, sind, dass
auf der Leiterplatte ein Anschlussteil bestückt ist, insbesondere lötverbunden ist,
wobei das Anschlussteil einen Beabstandungsabschnitt und einen Verbindungsabschnitt aufweist,
wobei die Leiterplatte mittels des Beabstandungsabschnitts von dem Gehäuseteil beabstandet ist,
wobei der Verbindungsabschnitt einen Gewindeabschnitt aufweist,
insbesondere wobei der Verbindungsabschnitt elektrisch leitend mit zumindest einer Leiterbahn auf der Leiterplatte verbunden ist.

Von Vorteil ist dabei, dass das Anschlussteil sicher mit der Leiterplatte verbindbar ist. Vorteilhafterweise ist das Anschlussteil in einem Arbeitsschritt mit weiteren Bauteilen auf der Leiterplatte bestückbar und in einem weiteren Arbeitsschritt mit den weiteren Bauteilen mit der Leiterplatte lötverbindbar. Somit ist der Umweltschutz verbessert.

Vorteilhafterweise sind die Leiterplatte und auf der Leiterplatte bestückte elektrische Bauteile beabstandbar von dem Gehäuseteil mittels des Beabstandungsabschnitts. Somit ist die Durchschlagsfestigkeit des Elektrogerätes verbessert. Spannungsüberschläge von den elektrischen Bauteilen zu dem Gehäuseteil sind vermeidbar.

Bei einer vorteilhaften Ausgestaltung ist das Anschlussteil als Verbundteil ausgeführt, wobei der Verbindungsabschnitt aus einem elektrisch leitenden Material hergestellt ist, insbesondere aus Metall hergestellt ist, wobei der Beabstandungsabschnitt aus einem elektrisch isolierenden Material hergestellt ist, insbesondere aus Kunststoff hergestellt ist. Von Vorteil ist dabei, dass das Anschlussteil mittels des Verbindungsabschnitts in einfacher Art und Weise mit der Leiterplatte lötverbindbar ist. Mittels des elektrisch isolierend ausgeführten Beabstandungsabschnitts sind die Leiterplatte und auf der Leiterplatte bestückte elektrische Bauteile von dem Gehäuseteil beabstandbar. Somit ist eine Luftstrecke zwischen der Leiterplatte mit den elektrischen Bauteilen und dem Gehäuseteil vorgebbar. Die Sicherheit des Elektrogerätes ist verbessert.

Bei einer vorteilhaften Ausgestaltung ist der Beabstandungsabschnitt als Kunststoffspritzgussteil ausgeführt. Von Vorteil ist dabei, dass der Beabstandungsabschnitt in einfacher Art und Weise kostengünstig herstellbar ist.

Bei einer vorteilhaften Ausgestaltung ist der Beabstandungsabschnitt angespritzt an den Verbindungsabschnitt. Von Vorteil ist dabei, dass der Beabstandungsabschnitt in einfacher Art und Weise sicher verbindbar ist mit dem Verbindungsabschnitt. Vorteilhafterweise ist der Beabstandungsabschnitt in einem einzigen Arbeitsschritt herstellbar und verbindbar mit dem Verbindungsabschnitt.

Bei einer vorteilhaften Ausgestaltung ist der Verbindungsabschnitt zumindest teilweise überdeckt von dem Beabstandungsabschnitt. Von Vorteil ist dabei, dass der Beabstandungsabschnitt den Verbindungsabschnitt zumindest teilweise umgibt. Dadurch ist die Verbindung des Beabstandungsabschnitts mit dem Verbindungsabschnitt mechanisch stabil und sicher ausführbar.

Bei einer vorteilhaften Ausgestaltung umgreift der Beabstandungsabschnitt eine Kante, insbesondere Blechkante, des Verbindungsabschnitts. Von Vorteil ist dabei, dass der Beabstandungsabschnitt die Kante des Verbindungsabschnitts zumindest teilweise umgibt. Somit sind die mechanische Stabilität und die Sicherheit der Verbindung des Beabstandungsabschnitts mit dem Verbindungsabschnitt verbessert.

Bei einer vorteilhaften Ausgestaltung ist die Leiterplatte mit elektrischen Bauteilen bestückt, wobei der Beabstandungsabschnitt derart zwischen der Leiterplatte und dem Gehäuseteil angeordnet ist, dass die elektrischen Bauteile auf der Leiterplatte einen Mindestabstand zum Gehäuseteil aufweisen. Von Vorteil ist dabei, dass die Durchschlagfestigkeit des Elektrogerätes verbessert ist. Somit ist die Sicherheit des Elektrogerätes verbessert.

Bei einer vorteilhaften Ausgestaltung ist der Abstand zwischen den elektrischen Bauteilen und dem Gehäuseteil, also die Luftstrecke, größer als 5 mm. Von Vorteil ist dabei, dass die Durchschlagspannung des Elektrogerätes größer als 10 kV ist. Somit ist ein sicherer Betrieb des Elektrogerätes auch bei hohen Betriebsspannungen ermöglicht.

Bei einer vorteilhaften Ausgestaltung weist der Verbindungsabschnitt zumindest einen Anschlussabschnitt, insbesondere also ein Anschlussfüßchen, zumindest einen Auflageabschnitt und den Gewindeabschnitt auf. Von Vorteil ist dabei, dass der Verbindungsabschnitt kompakt ausführbar ist.

Bei einer vorteilhaften Ausgestaltung ist der Verbindungsabschnitt einstückig ausgeführt. Von Vorteil ist dabei, dass der Verbindungsabschnitt kostengünstig fertigbar ist. Dabei sind Bauteile einsparbar, der Umweltschutz ist also verbessert.

Bei einer vorteilhaften Ausgestaltung ist der Verbindungsabschnitt als Stanzbiegeteil ausgeführt, insbesondere als Stanzbiegeblechteil. Von Vorteil ist dabei, dass der Verbindungsabschnitt in einfacher Art und Weise fertigbar ist.

Bei einer vorteilhaften Ausgestaltung ragt ein oder der Anschlussabschnitt durch eine Bohrung in der Leiterplatte hindurch und ist mit einer Leiterbahn der Leiterplatte lötverbunden. Von Vorteil ist dabei, dass das Anschlussteil im gleichen Arbeitsschritt wie die auf der Leiterplatte bestückten elektrischen Bauteile mit der Leiterplatte lötverbindbar ist.

Bei einer vorteilhaften Ausgestaltung umgibt die senkrechte Projektion des Auflageabschnitts in die Leiterplattenebene die senkrechte Projektion der Bohrung in die Leiterplattenebene mit einem Winkel in Umfangsrichtung der Projektion der Bohrung von mehr als 180°, insbesondere mehr als 230°. Von Vorteil ist dabei, dass das Anschlussteil kippsicher auf der Leiterplatte anordenbar ist. Die Sicherheit beim Verlöten des Verbindungsabschnitts ist verbessert, da der Anschlussabschnitt oder die Anschlussabschnitte sicher in der Bohrung oder den Bohrungen angeordnet sind. Das Risiko eines Lötfehlers ist reduzierbar.

Bei einer vorteilhaften Ausgestaltung erstreckt sich der Auflageabschnitt senkrecht zu einem Normalenvektor der Leiterplattenebene der Leiterplatte. Von Vorteil ist dabei, dass das Anschlussteil kippsicher auf der Leiterplatte anordenbar ist. Das Anschlussteil weist eine große der Leiterplatte zugewandte Oberfläche auf. Die der Leiterplatte zugewandte Oberfläche des Auflageabschnitts beträgt vorteilhafterweise mindestens 30 % der Gesamtoberfläche des Auflageabschnitts, insbesondere 40 %.

Vorteilhafterweise ist ein Ausbrechen des mit der Leiterplatte lötverbundenen Anschlussteils verhinderbar.

Bei einer vorteilhaften Ausgestaltung weist das Gehäuseteil ausgestanzte durch das Gehäuseteil durchgehende Ausnehmungen auf, wobei durch eine der Ausnehmungen ein Schraubteil hindurchführbar ist und/oder der Gewindeabschnitt fluchtend zu der Ausnehmung angeordnet ist, wobei mittels des Schraubteils das Gehäuseteil und der Verbindungsabschnitt elektrisch leitend verbindbar sind. Von Vorteil ist dabei, dass mittels des Schraubteils elektrische Bauteile auf der Leiterplatte mit dem Erdpotential verbindbar sind. Somit ist eine wahlweise Verbindung mit dem Erdpotential ermöglicht.

Vorteilhafterweise ist das Elektrogerät anpassbar an verschiedene Anwendungen, die unterschiedliche Niederspannungsnetze zur elektrischen Stromversorgung erforderlich machen. Bei einem IT-System, das als erdfreies Netz ausgeführt ist, wird das Elektrogerät ohne Schraubteil verwendet, da die elektrischen Bauteile auf der Leiterplatte von dem geerdeten Gehäuseteil isoliert sein müssen. IT-Systeme werden in kleinen Netzen mit geringer Ausdehnung und hohen Anforderungen an die Fehlersicherheit verwendet, beispielsweise in Krankenhäusern. Es sind zusätzliche Schutzmaßnahmen zum Personenschutz erforderlich, wie beispielsweise Isolationsüberwachungseinrichtungen, Überstromschutzeinrichtungen, Fehlerstromschutzeinrichtungen und/oder Fehlerspannungsschutzeinrichtungen.

Bei Niederspannungsnetzen mit Neutralleiter, wie beispielsweise TN-Systeme oder TT-Systeme, werden die elektrischen Bauteile teilweise mit dem Erdpotential verbunden. Dadurch sind Fehlerströme leichter zu erkennen als in einem IT-System, beispielsweise mittels Fehlerstromschutzschaltern. Die Niederspannungsnetze mit Neutralleiter sind also deutlich größer ausführbar als das IT-System.

Die Ausnehmung für das Schraubteil ist vorteilhafterweise in einem Arbeitsschritt mit den weiteren Ausnehmungen, beispielsweise Belüftungslöcher, herstellbar.

Vorteilhafterweise sind die elektrischen Bauteile mittels des Schraubteils mit dem geerdeten Gehäuseteil verbindbar. Somit ist das Elektrogerät sowohl für Netze mit Neutralleiter als auch für Netze ohne Neutralleiter verwendbar. Die Anpassung an das jeweilige Netz erfolgt in einfacher Art und Weise mittels Einschrauben des Schraubteils in das Anschlussteil beziehungsweise Lösen und Entfernen des Schraubteils.

Bei einer vorteilhaften Ausgestaltung fungiert das Gehäuseteil als Erdanschluss. Von Vorteil ist dabei, dass das Elektrogerät kompakt ausführbar ist. Dabei sind Bauteile einsparbar. Der Umweltschutz ist verbessert.

Bei einer vorteilhaften Ausgestaltung ist ein Schraubteil durch eine Ausnehmung im Gehäuseteil hindurchgeführt und mit dem Gewindeabschnitt schraubverbunden, insbesondere wobei diese Schraubverbindung selbstsichernd ausgeführt ist, wobei das Schraubteil das Gehäuseteil und den Verbindungsabschnitt elektrisch leitend verbindet. Von Vorteil ist dabei, dass die elektrisch leitende Verbindung zwischen dem Gehäuseteil und dem Verbindungsabschnitt in einfacher Art und Weise herstellbar ist. Diese Verbindung ist sicher ausführbar, wobei die Schraube schwingungssicher verbindbar ist.

Bei einer vorteilhaften Ausgestaltung ist zwischen einem Schraubenkopf des Schraubteils und dem Gehäuseteil eine Lochscheibe angeordnet. Von Vorteil ist dabei, dass die Auflagefläche zwischen dem Schraubteil und dem Gehäuseteil vergrößerbar ist, somit ist die elektrische Leitfähigkeit verbessert.

Bei einer vorteilhaften Ausgestaltung weist der Beabstandungsabschnitt eine Ausnehmung auf, durch welche das Schraubteil hindurchführbar, insbesondere hindurchgeführt, ist. Von Vorteil ist dabei, dass der Beabstandungsabschnitt zwischen dem Gehäuseteil und dem Verbindungsabschnitt einklemmbar ist. Dabei ist der Anpressdruck des Schraubteils gleichmäßig auf den das Schraubteil teilweise umgebenden Beabstandungsabschnitt verteilbar.

Vorteilhafterweise fungiert der elastisch ausgeführte Beabstandungsabschnitt als mechanisches Dämpfungsmittel gegen Schwingungen des Gehäuseteils. Die Schwingungen des Gehäuseteils werden so gedämpft und die Leiterplatte ist schwingungsgedämpft im Gehäuse angeordnet.

Bei einer vorteilhaften Ausgestaltung erstreckt die Ausnehmung sich durch den Beabstandungsabschnitt hindurch. Von Vorteil ist dabei, dass das Schraubteil hindurchführbar ist durch den Beabstandungsabschnitt.

Bei einer vorteilhaften Ausgestaltung ist der Beabstandungsabschnitt im Wesentlichen U-förmig ausgeführt, wobei zwischen den Schenkeln des U ein Bereich des Schraubteils anordenbar, insbesondere angeordnet, ist. Von Vorteil ist dabei, dass Material einsparbar ist. Der Umweltschutz ist verbessert.

**Erfindungsgemäß** sind auf der Leiterplatte erste Kapazitäten bestückt, wobei die ersten Kapazitäten einen gemeinsamen Sternpunkt aufweisen, wobei der Sternpunkt elektrisch leitend mit dem Verbindungsabschnitt des Anschlussteils verbunden ist, insbesondere mittels Leiterbahnen. Von Vorteil ist dabei, dass Fehlerströme der ersten Kapazitäten ableitbar sind mittels des Anschlussteils. Somit ist die Sicherheit des Elektrogerätes verbessert.

**Erfindungsgemäß** ist der Sternpunkt mittels des Anschlussteils geerdet. Von Vorteil ist dabei, dass die Erdung in einfacher Art und Weise stabil und sicher ausführbar ist.

**Erfindungsgemäß** sind auf der Leiterplatte erste Kapazitäten bestückt, wobei die ersten Kapazitäten einen gemeinsamen Sternpunkt aufweisen, wobei der Sternpunkt elektrisch leitend mit einer vierten Kapazität verbunden ist, wobei die vierte Kapazität mit dem Verbindungsabschnitt des Anschlussteils verbunden ist, insbesondere mittels zumindest einer Leiterbahn der Leiterplatte, wobei die vierte Kapazität elektrisch zwischen dem Sternpunkt und dem Anschlussteil angeordnet ist, insbesondere wobei der Sternpunkt, die vierte Kapazität und das Anschlussteil eine Reihenschaltung bilden. Von Vorteil ist dabei, dass die vierte Kapazität als zusätzliches Filter fungiert, mittels dessen hochfrequente Störströme ableitbar sind. Die Spannungsstabilität ist verbessert. Somit ist die Sicherheit des Elektrogerätes verbessert.

**Erfindungsgemäß** ist die vierte Kapazität mittels des Anschlussteils geerdet. Von Vorteil ist dabei, dass Störströme zum Erdpotential ableitbar sind. Somit ist die Sicherheit des Elektrogerätes verbessert.

Bei einer vorteilhaften Ausgestaltung sind auf der Leiterplatte zweite Kapazitäten bestückt, wobei die zweiten Kapazitäten eine Reihenschaltung bilden, die einen Mittelabgriff aufweist, insbesondere wobei der Mittelabgriff elektrisch leitend mit dem Sternpunkt verbunden ist. Von Vorteil ist dabei, dass ein hochfrequenter Potentialbezug zwischen einem Wechselspannungsabschnitt und einem Gleichspannungsabschnitt der Schaltung herstellbar ist. Mittels dieses Potentialbezugs sind Potentialsprünge zwischen dem Wechselspannungsabschnitt und dem Gleichspannungsabschnitt der Schaltung unterdrückbar. Diese Potentialsprünge entstehen aufgrund des Schaltmusters des Elektrogerätes.

Bei einer vorteilhaften Ausgestaltung sind die zweiten Kapazitäten parallel geschaltet zu einer dritten Kapazität, insbesondere einem Zwischenkreiskondensator des Umrichters, angeordnet. Von Vorteil ist dabei, dass ein hochfrequenter Potentialbezug zwischen dem Zwischenkreis und dem Wechselspannungsabschnitt des Umrichters herstellbar ist. Somit ist der Erdanschluss über das Gehäuseteil entlastbar.

Bei einer vorteilhaften Ausgestaltung weist das Elektrogerät einen mehrphasigen eingangsseitigen Wechselspannungsanschluss auf, der für jede Phase jeweils ein Anschlussmittel aufweist, wobei der Wechselspannungsanschluss einen Gleichrichter speist, wobei ein jeweiliges Anschlussmittel mittels einer jeweiligen Phasenleitung mit einem jeweiligen Eingangspol des Gleichrichters verbunden ist, wobei jede Phasenleitung jeweils einen Abgriff aufweist, wobei zwischen jedem Abgriff und dem Sternpunkt jeweils eine erste Kapazität elektrisch angeordnet ist. Von Vorteil ist dabei, dass die ersten Kapazitäten als Filtersystem für das Elektrogerät fungieren. Mittels der ersten Kapazitäten sind hochfrequente Fehlerströme ableitbar zum Sternpunkt. Somit ist die Sicherheit verbessert.

Bei einer vorteilhaften Ausgestaltung weist das Elektrogerät einen Wechselrichter auf, wobei zwischen dem Gleichrichter und dem Wechselrichter ein Spannungszwischenkreis mit der dritten Kapazität als Zwischenkreiskondensator angeordnet ist, insbesondere wobei der Wechselrichter aus der dritten Kapazität gespeist ist. Von Vorteil ist dabei, dass das Elektrogerät als Umrichter ausführbar ist. Mittels des Umrichters ist ein Elektromotor speisbar, dessen Drehfrequenz mittels des Umrichters einstellbar ist.

Bei einer vorteilhaften Ausgestaltung ist in jeder Phasenleitung zwischen dem jeweiligen Anschlussmittel und dem jeweiligen Abgriff für die jeweilige erste Kapazität eine jeweilige erste Induktivität angeordnet. Von Vorteil ist dabei, dass die ersten Kapazitäten und die ersten Induktivitäten einen Netzfilter für das Elektrogerät bilden. Somit ist die Sicherheit des Elektrogerätes verbessert.

Bei einer vorteilhaften Ausgestaltung ist in jeder Phasenleitung zwischen dem jeweiligen Abgriff für die jeweilige erste Kapazität und dem jeweiligen Eingangspol des Gleichrichters eine jeweilige zweite Induktivität angeordnet. Von Vorteil ist dabei, dass die ersten Kapazitäten mit den zweiten Induktivitäten einen Netzfilter für das Elektrogerät bilden. Somit ist die Sicherheit des Elektrogerätes verbessert.

Wichtige Merkmale der Erfindung bei dem Verfahren zur Herstellung eines Elektrogerätes, insbesondere wie zuvor beschrieben und/oder nach einem der auf das Elektrogerät gerichteten Schutzansprüche, einer Elektrogerätebaureihe, die mindestens zwei Varianten von Elektrogeräten aufweist, sind, dass
wahlweise eine erste oder eine zweite Variante hergestellt wird,
wobei in einem ersten Verfahrensschritt eine Leiterplatte mit zumindest einem Anschlussteil und Kondensatoren bestückt wird,
wobei die Kondensatoren einen gemeinsamen Sternpunkt aufweisen, insbesondere mit dem das Anschlussteil elektrisch leitend verbunden wird,
wobei in einem zweiten Verfahrensschritt die Leiterplatte in einem geerdeten Gehäuse mit einem Gehäuseteil angeordnet wird,
wobei der Sternpunkt bei der Herstellung der ersten Variante von dem geerdeten Gehäuse elektrisch isoliert ist,
wobei in einem optionalen dritten Verfahrensschritt zur Herstellung der zweiten Variante der Sternpunkt elektrisch leitend mit dem geerdeten Gehäuse verbunden wird, indem ein Verbindungsmittel, insbesondere ein Schraubteil, durch eine Ausnehmung in dem Gehäuseteil geführt und mit dem Anschlussteil lösbar verbunden wird.

Von Vorteil ist dabei, dass das Elektrogerät in einfacher Art und Weise anpassbar ist an den Betrieb in erdfreien Niederspannungsnetzen oder in Niederspannungsnetzen mit Neutralleiter.

Vorteilhafterweise ist die Verbindung elektrischer Bauteile mit dem geerdeten Gehäuseteil lösbar ausführbar. Das Elektrogerät ist also nachträglich umrüstbar für den Betrieb in andersartigen Niederspannungsnetzen.

Bei einer vorteilhaften Ausgestaltung wird beim dritten Verfahrensschritt das Schraubteil in das Anschlussteil eingeschraubt. Von Vorteil ist dabei, dass das Schraubteil in einfacher Art und Weise mit dem Anschlussteil verbindbar und lösbar ist. Vorteilhafterweise ist die Schraubverbindung selbstsichernd ausführbar. Somit ist das Schraubteil schwingungssicher mit dem Anschlussteil verbindbar.

Bei einer vorteilhaften Ausgestaltung wird das Schraubteil mit dem geerdeten Gehäuseteil elektrisch leitend verbunden, insbesondere wobei das Schraubteil das Gehäuseteil berührt. Von Vorteil ist dabei, dass das Schraubteil als elektrisches Verbindungsmittel fungiert. Vorteilhafterweise weist das Schraubteil einen geringeren elektrischen Widerstand auf als Kabelverbindungen. Somit ist eine niederohmige Verbindung des geerdeten Gehäuseteils mit dem Anschlussteil ermöglicht. Die Sicherheit ist also verbessert.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von Abbildungen näher erläutert:
In der Figur 1 ist ein Prinzipschaltbild eines erfindungsgemäßen Elektrogeräts gezeichnet.
Figur 2 zeigt eine Detailansicht eines erfindungsgemäßen Elektrogeräts in einer zweiten Variante in Draufsicht.
Figur 3 zeigt eine Detailansicht des erfindungsgemäßen Elektrogeräts in einer ersten Variante in Draufsicht.

In der Figur 4 ist eine Detailansicht des erfindungsgemäßen Elektrogeräts in der zweiten Variante in Schrägansicht gezeichnet, wobei ein Schraubteil explodiert dargestellt ist.

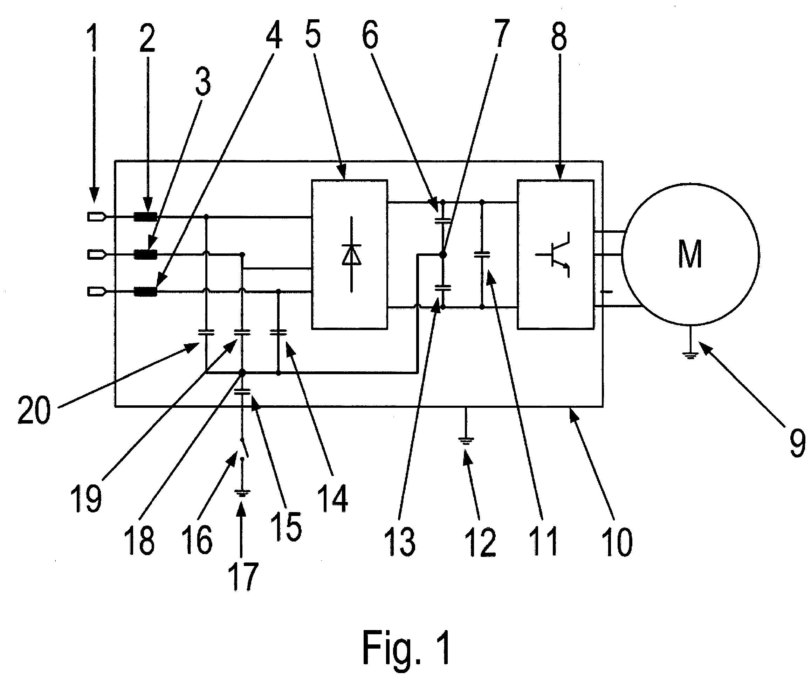

Das in Figur 1 gezeigte Prinzipschaltbild zeigt das Elektrogerät, vorzugsweise einen Umrichter, mit einem dreiphasigen Wechselspannungsanschluss 1, einem Gleichrichter 5 und einem Wechselrichter 8. Der Wechselspannungsanschluss 1 weißt drei Anschlussmittel auf. In Reihe geschaltet zu jedem Anschlussmittel ist jeweils eine Induktivität (2, 3, 4) angeordnet.

Der Gleichrichter 5 weist den jeweiligen Phasen des Wechselstroms zugeordnete Eingangspole auf.

Zwischen den Anschlussmitteln des Wechselspannungsanschlusses 1 und den Eingangspolen des Gleichrichters 5 weist jede Phase eine Phasenleitung auf.

Zwischen der jeweiligen Induktivität (2, 3, 4) und dem Gleichrichter 5 weist jede Phase eine Abzweigung auf, die mit jeweils einer ersten Kapazität (14, 19, 20) verbunden ist. Die Kapazitäten (14, 19, 20) sind mit einem gemeinsamen Sternpunkt 18 verbunden. Der Sternpunkt 18 ist mit einer Erdverbindung verbindbar mittels eines zwischengeordneten Verbindungsmittels 16. Zwischen dem Verbindungsmittel 16 und dem Sternpunkt 18 ist eine vierte Kapazität 15 angeordnet.

Im Spannungszwischenkreis zwischen dem Gleichrichter 5 und dem Wechselrichter 8 ist eine Reihenschaltung von zweiten Kapazitäten (6, 13) parallel geschaltet zu einer dritten Kapazität 11 angeordnet. Zwischen den zweiten Kapazitäten (6, 13) ist ein Mittelabgriff 7 angeordnet, der mit dem Sternpunkt 18 verbunden ist.

Die zweiten Kapazitäten (6, 13) und die dritte Kapazität 11 sind also im Gleichspannungszwischenkreis angeordnet. Die dritte Kapazität 11 wird auch als Zwischenkreiskondensator bezeichnet.

Die Bauteile des Umrichters sind in einem Gehäuse 10 angeordnet. Das Gehäuse 10 ist zumindest teilweise elektrisch leitend ausgeführt, vorzugsweise ist das Gehäuse 10 aus einem metallischen Material hergestellt. Das Gehäuse 10 ist mit einem Erdanschluss 12 elektrisch leitend verbunden und ist somit geerdet.

Der Wechselrichter 8 ist ausgangsseitig mit einem Verbraucher verbunden, vorzugsweise ist der Verbraucher ein Motor M. Der Verbraucher weist ein Gehäuse auf, das mit einem Erdanschluss 9 elektrisch leitend verbunden ist, somit ist das Gehäuse des Verbrauchers geerdet.

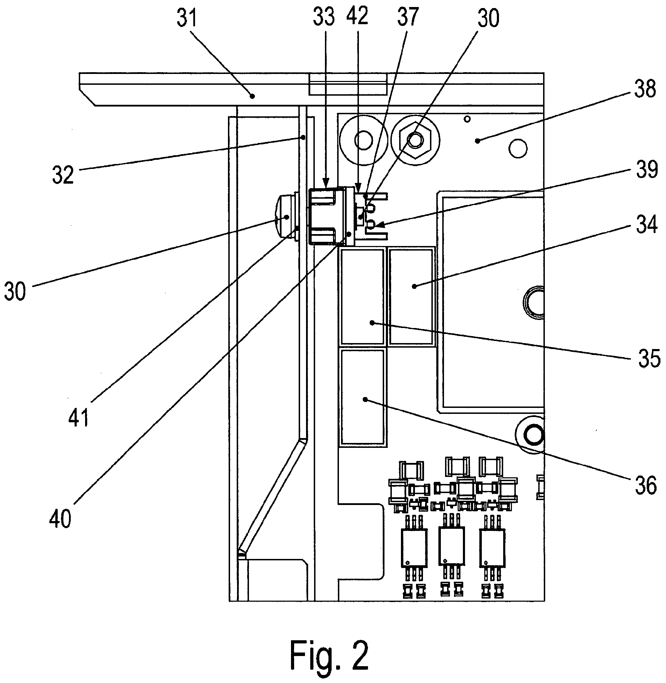

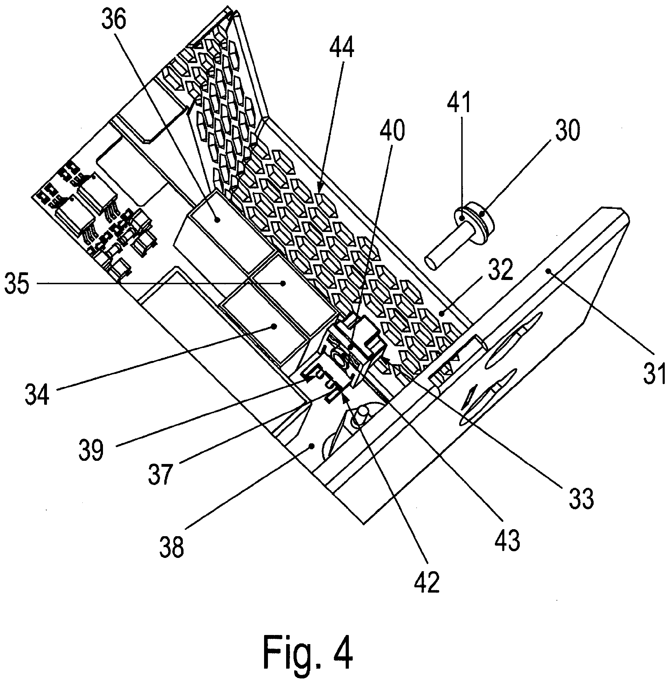

In Figur 2 und 4 ist eine Detailansicht der zweiten Variante des Umrichters gezeigt. Eine Leiterplatte 38 des Umrichters ist mit Kondensatoren (34, 35, 36) bestückt, die als Kapazitäten (14, 15, 19, 20) fungieren.

Die bestückte Leiterplatte 38 ist in einem Gehäuse angeordnet, das zumindest zwei Gehäuseteile (31, 32) aufweist. Das Gehäuseteil 32 weist zumindest eine Ausnehmung, insbesondere Bohrung, auf, durch welche ein Schraubteil 30 hindurchgeführt ist. Vorzugsweise ist zwischen dem Gehäuseteil 32 und einem Schraubkopf des Schraubteils 30 eine Lochscheibe 41 auf dem Schraubteil 30 angeordnet.

Das Gehäuseteil 32 weist weitere Ausnehmungen 44 auf zur Belüftung des Umrichters, insbesondere also Belüftungslöcher. Diese Ausnehmungen 44 sind zumindest teilweise in einer Ebene mit der Ausnehmung für das Schraubteil 30 angeordnet.

Vorzugsweise ist das Gehäuseteil 32 als Stanzbiegeteil ausgeführt, so dass die Ausnehmung für das Schraubteil 30 und die Ausnehmungen 44 zur Belüftung in einem Arbeitsschritt herstellbar sind. Die Ausnehmungen 44 sind also stanzbar.

Auf der Leiterplatte 38 ist ein Anschlussteil 40 zur elektrisch leitenden Verbindung von zumindest einer mit den Kondensatoren (34, 35, 36) verbundenen Leiterbahn mit dem Gehäuseteil 32 bestückt. Das Anschlussteil 40 weist also zumindest einen Anschlussabschnitt 39 auf, der in eine Bohrung in der Leiterplatte 38 eingesteckt ist, lötverbunden und/oder mit der Leiterbahn elektrisch leitend verbunden ist. Vorzugsweise weist das Anschlussteil 40 zwei Anschlussabschnitte 39 auf.

Mit dem Anschlussteil 40 ist das durch das Gehäuseteil 32 hindurchgeführte Schraubteil 30 verbunden, insbesondere auch elektrisch leitend verbunden. Dazu weist das Anschlussteil 40 einen Gewindeabschnitt 43 auf, in den das Schraubteil 30 eingeschraubt ist.

Das Anschlussteil 40 weist einen Auflageabschnitt 37 auf. Dieser Auflageabschnitt 37 erstreckt sich senkrecht zum Normalenvektor der Leiterplattenebene der Leiterplatte 38 von einem Randbereich der Leiterplatte 38 in die Leiterplatte 38 hinein. Vorzugsweise ist der Auflageabschnitt 37 U-förmig ausgeführt. Vorzugsweise ist der Anschlussabschnitt 39 zwischen den Schenkeln des U-förmigen Auflageabschnittes 37 angeordnet. Dabei erstreckt sich der Anschlussabschnitt 39 vom Auflageabschnitt 37 aus.

Die senkrechte Projektion des Auflageabschnitts 37 in die Leiterplattenebene umgibt die senkrechte Projektion der Bohrung in die Leiterplattenebene mit einem Winkel in Umfangsrichtung der Projektion der Bohrung von mehr als 180°, insbesondere mehr als 230°. Dieser Winkel ist der Umfangswinkel zum Schwerpunkt der Bohrung in der Leiterplatte 38.

Die Leiterplatte 38 ist eben ausgeführt und weist Epoxidharz auf.

Unter Leiterplattenebene versteht der Fachmann diejenige Ebene, die die Leiterplatte 38 bei verschwindender Leiterplattendicke aufweist.

Das Anschlussteil 40 weist einen einstückigen Verbindungsabschnitt 42 auf, der den Gewindeabschnitt 43, den Anschlussabschnitt 39 und den Auflageabschnitt 37 aufweist. Der Verbindungsabschnitt 42 ist als Stanzbiegeteil ausgeführt, vorzugsweise als Stanzbiegeblechteil ausgeführt. Vorzugsweise ist der Verbindungsabschnitt 42 aus metallischem Material gefertigt. Somit ist der Verbindungsabschnitt 42 elektrisch leitend ausgeführt.

In einem weiteren nicht dargestellten Ausführungsbeispiel weist der Verbindungsabschnitt 42 eine Ausnehmung auf, in der eine Gewindehülse aufgenommen ist, insbesondere verschweißt oder verlötet ist. Die Gewindehülse weist ein Innengewinde auf zur Verbindung mit dem Schraubteil 30.

Das Anschlussteil 40 weist einen Beabstandungsabschnitt 33 auf. Der Beabstandungsabschnitt 33 beabstandet das Gehäuseteil 32 von dem Verbindungsabschnitt 42. Der Beabstandungsabschnitt 33 ist elektrisch isolierend ausgeführt. Vorzugsweise ist der Beabstandungsabschnitt 33 aus Kunststoff gefertigt, insbesondere als Kunststoffspritzgussteil. Vorzugsweise wird der Kunststoff an den Verbindungsabschnitt 42 angespritzt. Das Anschlussteil 40 ist ein Verbundteil, vorzugsweise ein Verbundteil aus Kunststoff und Metall.

Der Beabstandungsabschnitt 33 weist eine Ausnehmung auf, durch welche das Schraubteil 30 hindurchführbar ist. Diese Ausnehmung ist als durchgehende Ausnehmung ausgeführt und erstreckt sich von dem Gewindeabschnitt 43 zu dem Gehäuseteil 32. Vorzugsweise ist der Beabstandungsabschnitt 33 U-förmig ausgeführt. Vorzugsweise ist ein Abschnitt des Schraubteils 30, vorzugsweise ein Gewindeabschnitt, zwischen den Schenkeln des U angeordnet.

Der Abstand zwischen dem Verbindungsabschnitt 42 und dem Gehäuseteil 32 ist mindestens so groß wie die Luftstrecke zwischen der bestückten Leiterplatte 38 und dem Gehäuseteil 32. Somit verbessert der Beabstandungsabschnitt 33 die Durchschlagfestigkeit des Umrichters. Vorzugsweise beträgt der von dem Beabstandungsabschnitt 33 bewirkte Abstand zwischen der bestückten Leiterplatte 38 und dem Gehäuseteil 32, also die Luftstrecke, mindestens 5 mm, was einer Durchschlagspannung von mindestens 10 kV entspricht.

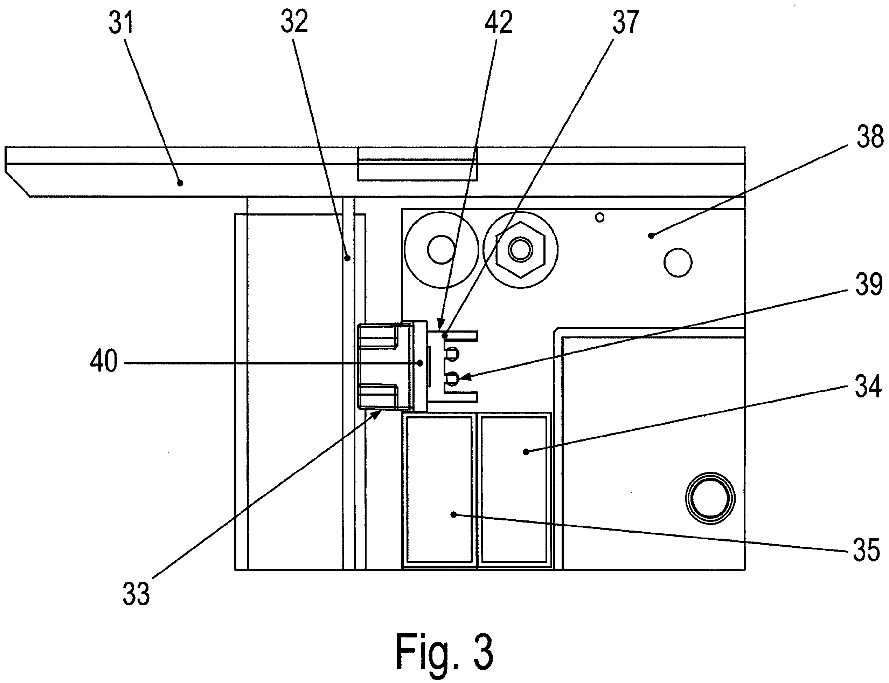

Figur 3 zeigt eine Detailansicht der ersten Variante des Umrichters.

Bei der ersten Variante ist wie bei der zweiten Variante das Anschlussteil 40 auf der Leiterplatte 38 bestückt. Dabei ist aber bei der ersten Variante der Verbindungsabschnitt 42 elektrisch isoliert von dem Gehäuseteil 32 angeordnet. Der Beabstandungsabschnitt 33 fungiert als Isoliermittel. Vorzugsweise ist der Beabstandungsabschnitt 33 beabstandet von dem Gehäuseteil 32 angeordnet. Dabei ist der Luftspalt zwischen dem Beabstandungsabschnitt 33 und dem Gehäuseteil 32 kleiner als 1 mm, vorzugsweise kleiner als 0,5 mm.

Der Umrichter weist bei der ersten Variante also kein Verbindungsmittel, insbesondere Schraubteil 30, auf, dass das Gehäuseteil 32 und das Anschlussteil 40 elektrisch leitend miteinander verbindet. Dabei fungiert die Ausnehmung für das Schraubteil 30 als Belüftungsloch für den Umrichter.

Bei einem weiteren nicht dargestellten erfindungsgemäßen Ausführungsbeispiel ist das Anschlussteil 40 in SMD-Technik mittels Oberflächentechnik mit der Leiterplatte 38 verbunden. Dazu fungiert der Auflageabschnitt 37 des Verbindungsteils 40 gleichzeitig als Verbindungsabschnitt 42.

### Bezugszeichenliste

M Motor
1 Wechselspannungsanschluss
2 Induktivität
3 Induktivität
4 Induktivität
5 Gleichrichter
6 Kapazität
7 Mittelabgriff
8 Wechselrichter
9 Erdverbindung
10 Gehäuse
11 Kapazität
12 Erdverbindung
13 Kapazität
14 Kapazität
15 Kapazität
16 Verbindungsmittel
17 Erdverbindung
18 Sternpunkt
19 Kapazität
20 Kapazität
30 Schraubteil
31 Gehäuseteil
32 Gehäuseteil
33 Beabstandungsabschnitt
34 Kondensator
35 Kondensator
36 Kondensator
37 Auflageabschnitt
38 Leiterplatte
39 Anschlussabschnitt
40 Anschlussteil
41 Lochscheibe
42 Verbindungsabschnitt
43 Gewindeabschnitt
44 Ausnehmung

## Patentansprüche

1. Elektrogerät, insbesondere Umrichter, aufweisend eine Leiterplatte (38) und ein Gehäuseteil (32),
**wobei** auf der Leiterplatte (38) ein Anschlussteil (40) bestückt ist, insbesondere lötverbunden ist,
wobei das Anschlussteil (40) einen Beabstandungsabschnitt (33) und einen Verbindungsabschnitt (42) aufweist,
wobei die Leiterplatte (38) mittels des Beabstandungsabschnitts (33) von dem Gehäuseteil (32) beabstandet ist,
wobei der Verbindungsabschnitt (42) einen Gewindeabschnitt (43) aufweist,
wobei der Verbindungsabschnitt (42) elektrisch leitend mit zumindest einer Leiterbahn auf der Leiterplatte (38) verbunden ist,
**dadurch gekennzeichnet, dass**
**auf der Leiterplatte (38) erste Kapazitäten (14, 19, 20) bestückt sind,**
**wobei die ersten Kapazitäten (14, 19, 20) einen gemeinsamen Sternpunkt (18) aufweisen,**
**wobei der Sternpunkt (18) elektrisch leitend mit dem Verbindungsabschnitt (42) des Anschlussteils (40) mittels Leiterbahnen verbunden ist,**
**oder**
**wobei der Sternpunkt (18) elektrisch leitend mit einer vierten Kapazität (15) verbunden ist,**
**wobei die vierte Kapazität (15) mit dem Verbindungsabschnitt (42) des Anschlussteils (40) verbunden ist,**
**wobei die vierte Kapazität (15) elektrisch zwischen dem Sternpunkt (18) und dem Anschlussteil (40) angeordnet ist,**
**wobei das Gehäuseteil eine durchgehende Ausnehmung (44) aufweist,**
**wobei durch die Ausnehmung (44) ein Schraubteil (30) hindurchführbar ist und mit dem Gewindeabschnitt (43) schraubverbindbar ist,**
**wobei mittels des Schraubteils (30) das Gehäuseteil (32) und der Verbindungsabschnitt (42) elektrisch leitend verbindbar sind,**
**insbesondere wobei das Gehäuseteil (32) als Erdanschluss (17) fungiert.**

2. Elektrogerät nach Anspruch 1,
**dadurch gekennzeichnet, dass**
das Anschlussteil (40) als Verbundteil ausgeführt ist,
wobei der Verbindungsabschnitt (42) aus einem elektrisch leitenden Material hergestellt ist, insbesondere aus Metall hergestellt ist,
wobei der Beabstandungsabschnitt (33) aus einem elektrisch isolierenden Material hergestellt ist, insbesondere aus Kunststoff hergestellt ist.

3. Elektrogerät nach mindestens einem der vorangegangenen Ansprüche,
**dadurch gekennzeichnet, dass**
der Beabstandungsabschnitt (33) als Kunststoffspritzgussteil ausgeführt ist,
insbesondere wobei der Beabstandungsabschnitt (33) angespritzt ist an den Verbindungsabschnitt (42),
insbesondere wobei der Verbindungsabschnitt (42) zumindest teilweise überdeckt ist von dem Beabstandungsabschnitt (33) und/oder der Beabstandungsabschnitt (33) eine Kante, insbesondere Blechkante, des Verbindungsabschnitts (42) umgreift.

4. Elektrogerät nach mindestens einem der vorangegangenen Ansprüche,
**dadurch gekennzeichnet, dass**
die Leiterplatte (38) mit elektrischen Bauteilen bestückt ist,
wobei der Beabstandungsabschnitt (33) derart zwischen der Leiterplatte (38) und dem Gehäuseteil (32) angeordnet ist, dass die elektrischen Bauteile auf der Leiterplatte (38) einen Mindestabstand zum Gehäuseteil (32) aufweisen,
insbesondere wobei der Abstand zwischen den elektrischen Bauteilen und dem Gehäuseteil (32), also die Luftstrecke, größer ist als 5 mm.

5. Elektrogerät nach mindestens einem der vorangegangenen Ansprüche,
**dadurch gekennzeichnet, dass**
der Verbindungsabschnitt (42)
- zumindest einen Anschlussabschnitt (39), insbesondere also ein Anschlussfüßchen,
- zumindest einen Auflageabschnitt (37) und
- den Gewindeabschnitt (43)
aufweist,
insbesondere wobei der Verbindungsabschnitt (42) einstückig ausgeführt ist,
insbesondere wobei der Verbindungsabschnitt (42) als Stanzbiegeteil ausgeführt ist, insbesondere als Stanzbiegeblechteil.

6. Elektrogerät nach mindestens einem der vorangegangenen Ansprüche,
**dadurch gekennzeichnet, dass**
ein oder der Anschlussabschnitt (39) durch eine Bohrung in der Leiterplatte (38) hindurchragt und mit einer Leiterbahn der Leiterplatte (38) lötverbunden ist,
insbesondere wobei die senkrechte Projektion des Auflageabschnitts (39) in die Leiterplattenebene die senkrechte Projektion der Bohrung in die Leiterplattenebene umgibt mit einem Winkel in Umfangsrichtung der Projektion der Bohrung von mehr als 180°, insbesondere mehr als 230°,
und/oder dass
der Auflageabschnitt (37) sich senkrecht zu einem Normalenvektor der Leiterplattenebene der Leiterplatte (38) erstreckt.

7. Elektrogerät nach mindestens einem der vorangegangenen Ansprüche,
**dadurch gekennzeichnet, dass**
**das** Schraubteil (30) durch **die** Ausnehmung (44) im Gehäuseteil (32) hindurchgeführt ist und mit dem Gewindeabschnitt (43) schraubverbunden ist, wobei diese Schraubverbindung selbstsichernd ausgeführt ist,
wobei das Schraubteil (30) das Gehäuseteil (32) und den Verbindungsabschnitt (42) elektrisch leitend verbindet,
insbesondere wobei das Gehäuseteil (32) als Erdanschluss (17) fungiert,
insbesondere wobei zwischen einem Schraubenkopf des Schraubteils (30) und dem Gehäuseteil (32) eine Lochscheibe (41) angeordnet ist.

8. Elektrogerät nach mindestens einem der vorangegangenen Ansprüche,
**dadurch gekennzeichnet, dass**
der Beabstandungsabschnitt (33) eine Ausnehmung aufweist, durch welche das Schraubteil (30) hindurchführbar, insbesondere hindurchgeführt, ist,
insbesondere wobei die Ausnehmung sich durch den Beabstandungsabschnitt (33) hindurch erstreckt,
insbesondere wobei der Beabstandungsabschnitt (33) im Wesentlichen U-förmig ausgeführt ist, wobei zwischen den Schenkeln des U ein Bereich des Schraubteils (30) anordenbar, insbesondere angeordnet, ist.

9. Elektrogerät nach mindestens einem der vorangegangenen Ansprüche, **dadurch gekennzeichnet, dass** der Sternpunkt (18) mittels des Anschlussteils (40) geerdet ist, oder dass die vierte Kapazität (15) mittels des Anschlussteils (40) geerdet ist.

10. Elektrogerät nach mindestens einem der vorangegangenen Ansprüche,
**dadurch gekennzeichnet, dass**
auf der Leiterplatte (38) zweite Kapazitäten (6, 13) bestückt sind,
wobei die zweiten Kapazitäten (6, 13) eine Reihenschaltung bilden, die einen Mittelabgriff (7) aufweist,
insbesondere wobei der Mittelabgriff (7) elektrisch leitend mit dem Sternpunkt (18) verbunden ist,
und/oder dass
die zweiten Kapazitäten (6, 13) parallel geschaltet zu einer dritten Kapazität (11), insbesondere einem Zwischenkreiskondensator des Umrichters, angeordnet sind.

11. Elektrogerät nach mindestens einem der vorangegangenen Ansprüche,
**dadurch gekennzeichnet, dass**
das Elektrogerät einen mehrphasigen eingangsseitigen Wechselspannungsanschluss (1), der für jede Phase jeweils ein Anschlussmittel aufweist, aufweist,
wobei der Wechselspannungsanschluss (1) einen Gleichrichter (5) speist,
wobei das jeweilige Anschlussmittel mittels einer jeweiligen Phasenleitung mit einem jeweiligen Eingangspol des Gleichrichters (5) verbunden ist,
wobei jede Phasenleitung jeweils einen Abgriff aufweist,
wobei zwischen jedem Abgriff und dem Sternpunkt (18) jeweils eine erste Kapazität (15) elektrisch angeordnet ist.

12. Elektrogerät nach mindestens einem der vorangegangenen Ansprüche,
**dadurch gekennzeichnet, dass**
das Elektrogerät einen Wechselrichter (8) aufweist,
wobei zwischen dem Gleichrichter (5) und dem Wechselrichter (8) ein Spannungszwischenkreis mit der dritten Kapazität (11) als Zwischenkreiskondensator angeordnet ist, insbesondere wobei der Wechselrichter (8) aus der dritten Kapazität (11) gespeist ist,
und/oder dass
in jeder Phasenleitung zwischen dem jeweiligen Anschlussmittel und dem jeweiligen Abgriff für die jeweilige erste Kapazität (14, 19, 20) eine jeweilige erste Induktivität (2, 3, 4) angeordnet ist,
und/oder dass
in jeder Phasenleitung zwischen dem jeweiligen Abgriff für die jeweilige erste Kapazität (14, 19, 20) und dem jeweiligen Eingangspol des Gleichrichters (5) eine jeweilige zweite Induktivität angeordnet ist.

13. Verfahren zur Herstellung eines Elektrogerätes nach mindestens einem der vorangegangenen Ansprüche, einer Elektrogerätebaureihe, die mindestens zwei Varianten von Elektrogeräten aufweist,
**dadurch gekennzeichnet, dass**
wahlweise eine erste oder eine zweite Variante hergestellt wird,
wobei in einem ersten Verfahrensschritt eine Leiterplatte (38) mit zumindest einem Anschlussteil (40) und **als Kapazitäten** (**14, 15, 19, 20**) **fungierende** Kondensatoren (34, 35, 36) bestückt wird,
wobei die Kondensatoren (34, 35, 36) einen gemeinsamen Sternpunkt (18) aufweisen, insbesondere mit dem das Anschlussteil (40) elektrisch leitend verbunden wird,
wobei in einem zweiten Verfahrensschritt die Leiterplatte (38) in einem geerdeten Gehäuse (10) mit einem Gehäuseteil (32) angeordnet wird,
wobei der Sternpunkt (18) bei der Herstellung der ersten Variante von dem geerdeten Gehäuse (10) elektrisch isoliert ist,
wobei in einem optionalen dritten Verfahrensschritt zur Herstellung der zweiten Variante der Sternpunkt (18) elektrisch leitend mit dem geerdeten Gehäuse (10) verbunden wird, indem ein Verbindungsmittel, insbesondere ein Schraubteil (30), durch eine Ausnehmung in dem Gehäuseteil (32) geführt und mit dem Anschlussteil (40) lösbar verbunden wird.

14. Verfahren nach Anspruch 13,
**dadurch gekennzeichnet, dass**
beim dritten Verfahrensschritt das Schraubteil (30) in das Anschlussteil (40) eingeschraubt wird,
insbesondere wobei das Schraubteil (30) mit dem geerdeten Gehäuseteil (32) elektrisch leitend verbunden wird, insbesondere wobei das Schraubteil (30) das Gehäuseteil (32) berührt.

## Claims

1. Electrical device, in particular a converter, having a printed circuit board (38) and a casing part (32),
a terminal part (40) being fitted on, in particular solder-connected to, the printed circuit board (38),
the terminal part (40) having a spacer portion (33) and a connection portion (42),
the printed circuit board (38) being spaced apart from the casing part (32) by means of the spacer portion (33),
the connection portion (42) having a threaded portion (43),
the connection portion (42) being connected, in an electrically conductive manner, to at least one conductive track on the printed circuit board (38),
**characterised in that**
first capacitors (14, 19, 20) are fitted on the printed circuit board (38),
the first capacitors (14, 19, 20) having a common star point (18),
the star point (18) being connected, in an electrically conductive manner, to the connection portion (42) of the terminal part (40) by means of conductive tracks,
or
the star point (18) being connected, in an electrically conductive manner, to a fourth capacitor (15),
the fourth capacitor (15) being connected to the connection portion (42) of the terminal part (40),
the fourth capacitor (15) being electrically arranged between the star point (18) and the terminal part (40),
the casing part having a through-opening (44),
a screw part (30) being guidable through the opening (44) and screw-connectable to the threaded portion (43),
the casing part (32) and the connection portion (42) being able to be connected in an electrically conductive manner by means of the screw part (30),
the casing part (32) in particular acting as an earth terminal (17).

2. Electrical device according to claim 1,
**characterised in that**
the terminal part (40) is configured as a composite part,
the connection portion (42) being produced from an electrically conductive material, in particular from metal,
the spacer portion (33) being produced from an electrically insulating material, in particular from plastics material.

3. Electrical device according to at least one of the preceding claims,
**characterised in that**
the spacer portion (33) is configured as a plastics injection-moulded part,
the spacer portion (33) in particular being integrally moulded to the connection portion (42),
the connection portion (42) in particular being covered at least in part by the spacer portion (33) and/or the spacer portion (33) encompassing an edge, in particular a plate edge, of the connection portion (42).

4. Electrical device according to at least one of the preceding claims,
**characterised in that**
the printed circuit board (38) is fitted with electrical components,
the spacer portion (33) being arranged between the printed circuit board (38) and the casing part (32) in such a way that the electrical components on the printed circuit board (38) have a minimum distance from the casing part (32),
the distance between the electrical components and the casing part (32), i.e. the air gap, being greater than 5 mm.

5. Electrical device according to at least one of the preceding claims,
**characterised in that**
the connection portion (42) has
- at least one terminal portion (39), in particular therefore a terminal base,
- at least one bearing portion (37) and
- the threaded portion (43),
the connection portion (42) in particular being configured in one piece,
the connection portion (42) in particular being configured as a punched-bent part, in particular as a sheet-metal punched-bent part.

6. Electrical device according to at least one of the preceding claims,
**characterised in that**
a or the terminal portion (39) protrudes through a hole in the printed circuit board (38) and is solder-connected to a conductive track of the printed circuit board (38),
the vertical projection of the bearing portion (39) into the printed circuit board plane in particular surrounding the vertical projection of the hole into the printed circuit board plane, at an angle in the circumferential direction of the projection of the hole of more than 180°, in particular of more than 230°,
and/or **in that**
the bearing portion (37) extends perpendicularly to a normal vector of the printed circuit board plane of the printed circuit board (38).

7. Electrical device according to at least one of the preceding claims,
**characterised in that**
the screw part (30) is guided through the opening (44) in the casing part (32) and is screw-connected to the threaded portion (43), this screw connection being configured to be self-locking,
the screw part (30) connecting the casing part (32) and the connection portion (42) in an electrically conductive manner,
the casing part (32) in particular acting as an earth terminal (17),
a perforated disc (41) in particular being arranged between a screw head of the screw part (30) and the casing part (32).

8. Electrical device according to at least one of the preceding claims,
**characterised in that**
the spacer portion (33) has an opening through which the screw part (30) can be guided, in particular is guided,
the opening in particular extending through the spacer portion (33),
the spacer portion (33) in particular being substantially U-shaped, a region of the screw part (30) being arrangeable, in particular arranged, between the legs of the U.

9. Electrical device according to at least one of the preceding claims,
**characterised in that**
the star point (18) is earthed by means of the terminal part (40),
or **in that**
the fourth capacitor (15) is earthed by means of the terminal part (40).

10. Electrical device according to at least one of the preceding claims,
**characterised in that**
second capacitors (6, 13) are fitted on the printed circuit board (38),
the second capacitors (6, 13) forming a series circuit that has a mid-tap (7),
the mid-tap (7) in particular being connected to the star point (18) in an electrically conductive manner,
and/or **in that**
the second capacitors (6, 13) are connected in parallel with a third capacitor (11), in particular a DC link condenser of the converter.

11. Electrical device according to at least one of the preceding claims,
**characterised in that**
the electrical device has a multi-phase input-side AC voltage terminal (1), which has a respective terminal means for each phase,
the AC voltage terminal (1) feeding a rectifier (5),
each terminal means being connected to a particular input pole of the rectifier (5) by means of a respective phase line,
each phase line having a respective tap,
a respective first capacitor (15) being electrically arranged between each tap and the star point (18).

12. Electrical device according to at least one of the preceding claims,
**characterised in that**
the electrical device has an inverter (8),
a voltage DC link, which has the third capacitor (11) as the DC link condenser, being arranged between the rectifier (5) and the inverter (8), the inverter (8) in particular being fed from the third capacitor (11),
and/or **in that**
a respective first inductor (2, 3, 4) is arranged in each phase line between each terminal means and the respective tap for each first capacitor (14, 19, 20),
and/or **in that**
a respective second inductor is arranged in each phase line between each tap for the respective first capacitor (14, 19, 20) and the respective input pole of the rectifier (5).

13. Method for producing an electrical device, according to at least one of the preceding claims, of an electrical device product line that has at least two variants of electrical devices,
**characterised in that**
either a first or a second variant is produced,
in a first method step, a printed circuit board (38) being fitted with at least one terminal part (40) and condensers (34, 35, 36) that act as capacitors (14, 15, 19, 20),
the condensers (34, 35, 36) having a common star point (18), in particular being connected to the terminal part (40) in an electrically conductive manner,
in a second method step, the printed circuit board (38) being arranged in an earthed casing (10) having a casing part (32),
the star point (18) being electrically insulated from the earthed casing (10) when the first variant is produced,
in an optional third method step for producing the second variant, the star point (18) being connected to the earthed casing (10) in an electrically conductive manner by guiding a connection means, in particular a screw part (30), through an opening in the casing part (32) and releasably connecting said connection means to the terminal part (40).

14. Method according to claim 13,
**characterised in that**
in the third method step, the screw part (30) is screwed into the terminal part (40),
the screw part (30) in particular being connected to the earthed casing part (32) in an electrically conductive manner, the screw part (30) in particular being in contact with the casing part (32).

## Revendications

1. Appareil électrique, en particulier convertisseur, comprenant une carte de circuit imprimé (38) et un élément de boîtier (32),
un élément de connexion (40) étant monté, en particulier étant soudé, sur la carte de circuit imprimé (38), l'élément de connexion (40) comportant une portion d'espacement (33) et une portion de liaison (42),
la carte de circuit imprimé (38) étant espacée de l'élément de boîtier (32) au moyen de la portion d'espacement (33),
la portion de liaison (42) comportant une portion filetée (43),
la portion de liaison (42) étant reliée électriquement à au moins une piste conductrice de la carte de circuit imprimé (38),
**caractérisé en ce que**
des premiers éléments capacitifs (14, 19, 20) sont montés sur la carte de circuit imprimé (38),
les premiers éléments capacitifs (14, 19, 20) comportant un point neutre commun (18),
le point neutre (18) étant relié électriquement à la portion de liaison (42) de l'élément de connexion (40) au moyen de pistes conductrices,
ou
le point neutre (18) étant relié électriquement à un quatrième élément capacitif (15),
le quatrième élément capacitif (15) étant relié à la portion de liaison (42) de l'élément de connexion (40), le quatrième élément capacitif (15) étant disposé électriquement entre le point neutre (18) et l'élément de connexion (40),
l'élément de boîtier comportant un évidement traversant (44),
un élément de vissage (30) pouvant être passé à travers l'évidement (44) et pouvant être vissé sur la portion filetée (43),
l'élément de boîtier (32) et la portion de liaison (42) pouvant être reliés électriquement au moyen de l'élément de vissage (30),
en particulier l'élément de boîtier (32) fonctionnant comme une connexion à la terre (17).

2. Appareil électrique selon la revendication 1,
**caractérisé en ce que**
l'élément de connexion (40) est conçu comme un élément composite,
la portion de liaison (42) étant en un matériau électriquement conducteur, en particulier en métal,
la portion d'espacement (33) étant réalisée en un matériau électriquement isolant, en particulier en matière synthétique.

3. Appareil électrique selon l'une au moins des revendications précédentes,
**caractérisé en ce que**
la portion d'espacement (33) est conçue comme un élément moulé par injection de matière synthétique,
en particulier la portion d'espacement (33) étant moulée sur la portion de liaison (42),
en particulier la portion de liaison (42) étant au moins partiellement recouverte par la portion d'espacement (33) et/ou la portion d'espacement (33) s'engageant autour d'un bord, en particulier d'un bord de tôle, de la portion de liaison (42).

4. Appareil électrique selon l'une au moins des revendications précédentes,
**caractérisé en ce que**
la carte de circuit imprimé (38) est équipée de composants électriques,
la portion d'espacement (33) étant disposée entre la carte de circuit imprimé (38) et l'élément de boîtier (32) de telle sorte que les composants électriques sur la carte de circuit imprimé (38) soient à une distance minimale de l'élément de boîtier (32),
en particulier la distance entre les composants électriques et l'élément de boîtier (32), donc l'espace d'air, étant supérieure à 5 mm.

5. Appareil électrique selon l'une au moins des revendications précédentes,
**caractérisé en ce que**
la portion de liaison (42) comporte
- au moins une portion de connexion (39), notamment un pied de connexion,
- au moins une portion d'appui (37) et
- la portion filetée (43),
en particulier la portion de liaison (42) étant réalisée d'une seule pièce,
en particulier la portion de liaison (42) étant réalisée sous la forme d'un élément embouti et plié, en particulier sous la forme d'un élément en tôle embouti et plié.

6. Appareil électrique selon l'une au moins des revendications précédentes,
**caractérisé en ce que**
une ou la portion de liaison (39) fait saillie à travers un alésage ménagé dans la carte de circuit imprimé (38) et est soudée à une piste conductrice de la carte de circuit imprimé (38),
en particulier la projection verticale de la portion d'appui (39) dans le plan de la carte de circuit imprimé entourant la projection verticale de l'alésage dans le plan de la carte de circuit en formant dans la direction circonférentielle de la projection de l'alésage un angle de plus de 180°, en particulier de plus de 230°,
et/ou **en ce que**
la portion d'appui (37) s'étend perpendiculairement à un vecteur normal du plan de la carte de circuit imprimé (38) .

7. Appareil électrique selon l'une au moins des revendications précédentes,
**caractérisé en ce que**
la portion de vissage (30) passe à travers l'évidement (44) de l'élément de boîtier (32) et est vissée à la portion filetée (43), cette liaison par vissage étant conçue pour être autobloquante,
la portion de vissage (30) reliant électriquement l'élément de boîtier (32) et la portion de liaison (42), en particulier l'élément de boîtier (32) fonctionnant comme une connexion à la terre (17),
en particulier un disque perforé (41) étant disposé entre une tête de vis de l'élément de vissage (30) et l'élément de boîtier (32).

8. Appareil électrique selon l'une au moins des revendications précédentes,
**caractérisé en ce que**
la portion d'espacement (33) comporte un évidement à travers lequel l'élément de vissage (30) peut être passé, en particulier est passé,
en particulier l'évidement s'étendant à travers la portion d'espacement (33),
en particulier la portion d'espacement (33) étant sensiblement en forme de U, une région de l'élément de vissage (30) pouvant être disposée, en particulier étant disposée, entre les branches du U.

9. Appareil électrique selon l'une au moins des revendications précédentes,
**caractérisé en ce que**
le point neutre (18) est mis à la terre au moyen de l'élément de connexion (40),
ou **en ce que**
le quatrième élément capacitif (15) est mis à la terre au moyen de l'élément de connexion (40).

10. Appareil électrique selon l'une au moins des revendications précédentes,
**caractérisé en ce que**
des deuxièmes éléments capacitifs (6, 13) sont montés sur la carte de circuit imprimé (38),
les deuxièmes éléments capacitifs (6, 13) formant un circuit série qui comporte une prise médiane (7),
en particulier la prise médiane (7) étant reliée électriquement au point neutre (18),
et/ou **en ce que**
les deuxièmes éléments capacitifs (6, 13) sont montés en parallèle à un troisième élément capacitif (11), en particulier un condensateur de circuit intermédiaire du convertisseur.

11. Appareil électrique selon l'une au moins des revendications précédentes,
**caractérisé en ce que**
l'appareil électrique comporte une borne de tension alternative polyphasée côté entrée (1) qui comporte un moyen de connexion pour chaque phase,
la borne de tension alternative (1) alimentant un redresseur (5),
le moyen de connexion respectif étant relié à un pôle d'entrée respectif du redresseur (5) à l'aide d'une ligne de phase respective,
chaque ligne de phase comportant une prise,
un premier élément capacitif (15) étant disposé électriquement entre chaque prise et le point neutre (18) .

12. Appareil électrique selon l'une au moins des revendications précédentes,
**caractérisé en ce que**
l'appareil électrique comporte un onduleur (8),
un circuit intermédiaire de tension pourvu du troisième élément capacitif (11) comme condensateur de circuit intermédiaire étant disposé entre le redresseur (5) et l'onduleur (8), en particulier l'onduleur (8) étant alimenté à partir du troisième élément capacitif (11), et/ou **en ce que**
une première inductance respective (2, 3, 4) est disposée dans chaque ligne de phase entre le moyen de connexion respectif et la prise respective pour le premier élément capacitif respectif (14, 19, 20),
et/ou **en ce que**
une deuxième inductance respective est disposée dans chaque ligne de phase entre la prise respective destinée au premier élément capacitif respectif (14, 19, 20) et le pôle d'entrée respectif du redresseur (5).

13. Procédé de production d'un appareil électrique selon l'une au moins des revendications précédentes, d'une série d'appareils électriques comportant au moins deux variantes d'appareils électriques,
**caractérisé en ce que**
une première ou une deuxième variante est produite au choix,
dans une première étape de procédé une carte de circuit imprimé (38) étant équipée d'au moins un élément de connexion (40) et de condensateurs (34, 35, 36) fonctionnant comme des éléments capacitifs (14, 15, 19, 20),
les condensateurs (34, 35, 36) comportant un point neutre commun (18), en particulier auquel l'élément de connexion (40) est relié électriquement,
dans une deuxième étape de procédé la carte de circuit imprimé (38) étant disposée dans un boîtier, mis à la terre (10), pourvu d'un élément de boîtier (32),
le point neutre (18) étant isolé électriquement du boîtier (10) mis à la terre pendant la production de la première variante,
dans une troisième étape de procédé optionnelle de production de la deuxième variante le point neutre (18) étant relié électriquement au boîtier (10) mis à la terre du fait qu'un moyen de liaison, en particulier un élément de vissage (30), est passé à travers un évidement ménagé dans l'élément de boîtier (32) et est relié de manière amovible à l'élément de connexion (40).

14. Procédé selon la revendication 13,
**caractérisé en ce que**
dans la troisième étape de procédé l'élément de vissage (30) est vissé dans l'élément de connexion (40),
en particulier l'élément de vissage (30) étant relié électriquement à l'élément de boîtier (32) mis à la terre, en particulier l'élément de vissage (30) étant en contact avec l'élément de boîtier (32).
